# EUROPEAN PATENT SPECIFICATION

(11) **EP 1 670 143 B1**
(45) Date of publication and mention of the grant of the patent: **24.12.2008**
(21) Application number: 06110510.2
(22) Date of filing: 02.11.2000
(51) Int. Cl.: H03M 7/30

(54) **Variable length encoding of compressed data**
Kodierung mit variabler Länge für komprimierte Daten
Codage à longueur variable de données compressées

(30) Priority: 09.11.1999 US 164330; 28.03.2000 US 536638
(43) Date of publication of application: 14.06.2006
(62) Divisional of application: 00991715.4
(73) Proprietor: Nokia Corporation, 02150 Espoo (FI)
(72) Inventor: Le, Khiem, Coppell, Texas 75019 (US); Liu, Zhigang, Coppell, Texas 75019 (US); Leon, David, Irving, Texas 75038 (US)
(74) Representative: Derry, Paul Stefan

(56) References cited:
- US-A- 5 293 379
- CASNER S ET AL: "Compressing IP/UDP/RTP Headers for Low-Speed Serial Links" IETF INTERNET DRAFT, 27 July 1998 (1998-07-27), XP002125101
- DEGERMARK M ET AL: "LOW-LOSS TCP/IP HEADER COMPRESSION FOR WIRELESS NETWORKS" WIRELESS NETWORKS, ACM, NEW YORK, NY, US, vol. 3, no. 5, October 1997 (1997-10), pages 375-387, XP000728935 ISSN: 1022-0038
- HANDLEY M: "GERM: GENERIC RTP MULTIPLEXING" INTERNET ENGINEERING TASK FORCE, 11 November 1998 (1998-11-11), pages 1-7, XP002139359

## Description

The invention relates to data compression including packet header compression.

There are many areas where it is critical to be able to compress a sequence of values, in an manner that is efficient and robust to errors. An example is IP/UDP/RTP header compression to carry real-time IP-based multi-media traffic over cellular networks. Due to the large size of the IP/UDP/RTP header and the bandwidth limitations of cellular systems, compression efficiency is a must. Error robustness is also required due to the error-prone characteristics of the cellular link.

The RTP header compression described in Internet Engineering Task Force (IETF) RFC 2508, February 1999, achieves high compression efficiency on a lossless compressor-decompressor link. It can compress most of the headers to as low as two bytes. However, this scheme is not robust to errors. The problems encountered are error propagation and increased compressed header sizes. Error propagation refers here to the fact that if a compressed header is hit by an error, not only is this compressed header not decodable but the following compressed headers will likely not be decodable even though they are error free. Increased compressed header size refers here to the fact that because of the error recovery procedure, compressed headers on a lossy link are larger than the optimal 2 bytes achieved on a lossless link. Limitations of RFC 2508 are hereinafter discussed.

Header compression schemes take advantage of the fact that certain information fields carried in the headers either 1.) do not change (called here 'Type 1' header fields) or 2.) change in a fairly predictable way (called here 'Type 2' header fields). Other fields, referred to as 'Type 3' header fields, vary in such a way that they cannot be truly predicted.

Examples of Type 1 header fields are the IP address, UDP port number, RTP SSRC (synchronization source), etc. These fields need only be transmitted to the receiver/decompressor once during the course of a session (as part of the packet(s) transferred at session establishment, for example).

Examples of Type 2 header fields are the RTP time stamp, RTP sequence number, and IP ID fields. All have a tendency to increment by some constant amount from packet to packet. Thus, there is no need for these values to be transmitted within every header. It is only required that the decompressor be made aware of the constant increment (differential) value, called delta in RFC 2508. The decompressor utilizes these deltas to regenerate up-to-date Type 2 field values when reconstructing the original header. In other words, differential encoding is used to compress type 2 header fields.

The IP-ID field for most of IP stack implementations increments by a fixed amount for every packet sent by the source. Therefore as long as an RTP stream packets are not interleaved with other packets from the same source on the compressor-decompressor (CD)-channel, the IP-ID delta is constant and does not need to be transmitted.

An Example of a Type 3 header field is the RTP M-bit (Marker), which indicates the occurrence of some boundary in the media (e.g., end of a video frame). Because the media normally varies in unpredictable ways, this information cannot be truly predicted.

The above mentioned limitations of header compression schemes stem from the delta encoding used for type 2 fields. Because of differential encoding, if a single compressed header is lost, all the following compressed headers are not decodable because they are recursively predicted from a compressed header which is not decodable. This is what we called error propagation.

An algorithm used to recover from error propagation is known as the "twice" algorithm which can be used if the packet UDP checksum is transmitted in the compressed packet. Compressed packets on the CD-link carry a 4-bit sequence number which is incremented by one for each compressed packet sent by the compressor. The decompressor uses this sequence number to detect compressed packet loss on the link. If the sequence number increases by more than one, the decompressor hopes that all the compressed packet deltas have not changed since the last compressed packet delta and add one delta for each lost packet. The decompressor checks then that the assumption was valid by computing the decompressed packet UDP checksum and checking if it matches the transmitted UDP checksum.

The twice algorithm is too limiting. First, it requires transmission of the checksum (2 bytes) in every compressed packet and thus significantly reduces the compression efficiency. Second, for a typical audio stream, the twice algorithm works only if there has not been any TS or IP-ID jumps since the last decompressed packet.

When the decompressor is not able to decompress a packet, it sends an negative acknowledgment Nack to the compressor. Upon reception of Nack, the compressor has to send uncompressed header fields. The Nack mechanism thus incurs audio or video outages of a duration of at least one round-trip delay and decreased compression efficiency, since fields have to be sent uncompressed.

In order to limit error propagation, the compressor may use a refresh mechanism whereby it sends periodically uncompressed field values even though this is not requested by the decompressor. However such a mechanism further decreases compression efficiency.

Another limitation of RFC 2508 is the compressed header short sequence number. When the decompressor receives a header with a sequence number that is not consecutive from the previous one, packet loss is detected and a recovery scheme is employed to resynchronize the compressor and decompressor. Just using a short sequence number to detect packet loss is not robust to an error-prone link, such as wireless where 'long loss' may happen frequently. Long loss is defined as the loss of 'sequence cycle' or more packets in a row. When long loss occurs, the sequence number in the packet received by decompressor 'wraps around'. For example, assume the sequence number consists of k bits, hence the sequence cycle equals to 2^{k}. If 2^{k} packets are lost in a row, the decompressor fails to detect the packet losses since it still sees a consecutive sequence number in the incoming packets.

The invention is defined by the claims.

The specification describes a robust and efficient encoding scheme which in one embodiment is referred to as VLE (variable length encoding). VLE and other embodiments of the invention solve the error propagation and efficiency drop of the prior art.

The invention is based in part on the observation, that header type 2 fields received at the compression point shows an increasing trend. This implies that fields from consecutive headers tend to have the same MSBs (most significant bits) and differ only by their LSBs (least significant bits). Compression can thus be achieved by transmitting only the LSBs.

The described embodiments allow the compressor to determine the minimum number of LSBs to be sent such as this number be sufficient to allow correct decompression whatever the loss of previous compressed packets on the CD-link.

The described embodiments can be applied to any series of values. The more clustered (i.e. close to each other) the values, the higher the efficiency.

A method of compressing a current value into a minimum or reduced number of bits for transmission from a compressor to a decompressor described in this specification includes maintaining a series of at least one previous value at the compressor, each previous value having different k least significant bits and which have been transmitted to the decompressor; determining a value of k representing a smallest or reduced number of bits which allows successful decompression of the current value at the decompressor using as a reference value any value in the series of previous values; and transmitting the current value from the compressor to the decompressor in compressed form with the k least significant bits of the current value. The value of k may be determined by comparing the current value with the previous values to determine a maximum difference r between the current value and the previous values with k being an integer chosen to be the smallest integer which is greater than log₂^{(r)}+1. The decompressor may transmit at least one acknowledgment to the compressor which indicates that the decompressor has decompressed a value and the compressor may update the series of at least one previous value to discard an older at least one previous value. The decompressor may decompress the current value with a reference value of a last value of the series of at least one previous value to be decompressed as a value having k least significant bits identical to the k least significant bits of the received current value which is closest to the reference value. The decompressor may use a search interval which contains values which range from less than to greater than the reference value; and may choose from the values within the search interval the value having the identical k least significant bits. The values may be produced from mapping a reference value v_ref and the number of bits k to the series of at least one previous value and the current value; and the series of at least one previous value may be updated to have as an oldest value an oldest transmitted value which has been acknowledged to have been decompressed by the decompressor. The values may be a function of a reference value and the number of bits k. The function may be ]v_ref-2^{k-1}, v_ref+2^{k-1}]. The function may be ]v_ref, v_ref+2^{k}]. The at least one acknowledgment may be the received uncompressed or compressed value. The at least one acknowledgment may be the received compressed value including information used in coding a portion of the compressed value. The at least one acknowledgment may contain an oldest value in the series of the at least one previous value. The series of at least one previous value may be updated to discard older previous values based upon an estimated maximum number of values which can be lost during transmission in a sequence of values between the compressor and the decompressor. The compressed current value may encode the number k which is transmitted with the current value. The encoding may be Huffman encoding. The values may comprise RTP headers. The at least one acknowledgment may be an acknowledgment of an RTP SN header representing an acknowledgment of TS and IP-ID in the RTP header.

A system for compressing a current value into a minimum or reduced number of bits described in this specification includes a compressor which maintains a series of at least one previous value, each previous value having different k least significant bits; a decompressor which receives the current value compressed into a minimum or reduced number of k least significant bits from the compressor; and wherein the compressor determines a value of k representing a smallest number of bits which allows successful decompression of the current value at the decompressor using as a reference any value in the series of at least one previous value. The value of k may be determined by comparing the current value with the at least one previous value to determine a maximum difference r between the current value and the at least one previous value with k being an integer chosen to be the smallest integer which is greater than log₂^{(r)}+1. The decompressor may transmit at least one acknowledgment to the compressor which indicates that the decompressor has decompressed a value and the compressor may update the series of at least one previous value to discard an older at least one previous value. The decompressor may decompress the current value at the decompressor with a reference value of a last value of the series of at least one previous value to be decompressed as a value having k least significant bits identical to the k least significant bits of the received current value which is closest to the reference value. The decompressor may use a search interval which contains values which range from less than to greater than the reference value; and may choose from the values within the search interval the value having the identical k least significant bits. The compressor may produce the values from mapping a reference value v_ref and the number of bits k to the series of at least one previous value and the current value; and the series of at least one previous value may be updated to have as an oldest value an oldest transmitted value which has been acknowledged to have been decompressed by the decompressor. The function is ]v_ref-2^{k-1}, v_ref+2^{k-1}]. The function may be ]v_ref, v_ref+2^{k}]. The acknowledgments may be the received uncompressed value. The at least one acknowledgment may be the received compressed value. The at least one acknowledgment may be the received compressed value including information used in coding a portion of the compressed value. The series of at least one previous value may be updated by the compressor to discard at least one older previous value based upon an estimated maximum number of values which can be lost during transmission in a sequence of values between the compressor and the decompressor. The compressed current value may encode the number k which is transmitted with the current value. The values may comprise RTP headers. The at least one acknowledgment may be an acknowledgment of an RTP SN header representing an acknowledgment of TS and IP-ID in the RTP header.
Fig. 1 conceptually illustrates compression of information.
Fig. 2 conceptually illustrates decompression of information.
Fig. 3 illustrates the transition of a compressor from transmitting headers having a higher number of bits to headers having a lower number of bits using acknowledgments in accordance with the present invention.
Fig. 4 illustrates the transition of a compressor from transmitting headers with a first order of compression to headers with a second order of compression in accordance with the present invention.
Figs. 5 and 6 illustrate examples of the selection of the minimum number of bits k in accordance with the invention.
Figs. 7A and 7B illustrate the use of a sliding window of values stored by the compressor in accordance with the invention.
Fig. 8 illustrates an example of VLE encoding format using two encoding fields for transmitting the compressed value in accordance with the present invention.

### Basic Concepts and Rules

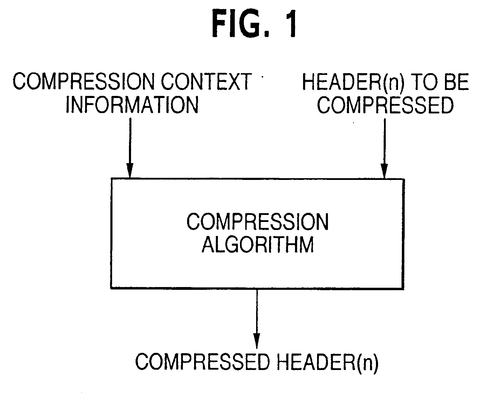

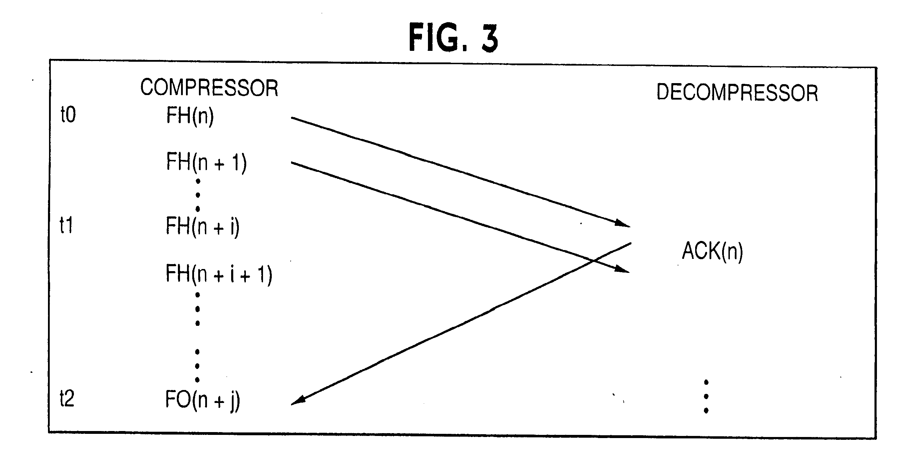

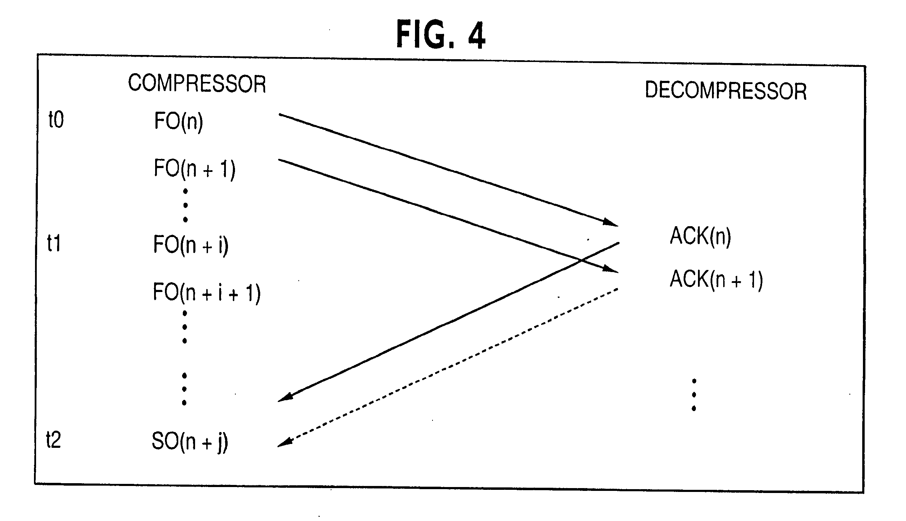

Fig. 1 illustrates conceptually compression information and examples thereof. Compression context information is a set, subset or representative of a subset of information which may be without limitation any type of information including a header used by a compressor as illustrated in Figs. 3 and 4 as an input to the compression algorithm to produce compressed information which may be without limitation a compressed header. The other input is from the source of the information to be compressed which is illustrated without limitation in the example as headers to be compressed.

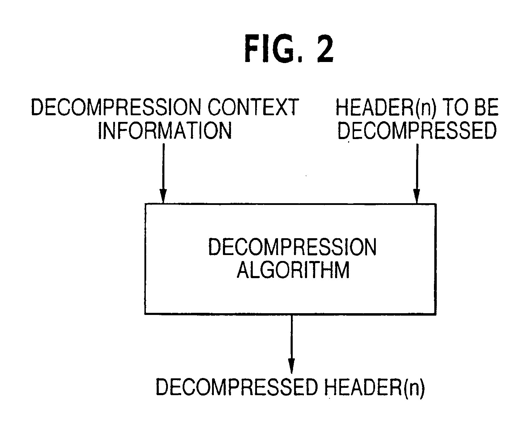

Fig. 2 illustrates conceptually decompression of information and examples thereof. Decompression context information is a set, subset or representation of a subset of information which may be without limitation of any type of information including a header used by a decompression as illustrated in Figs. 3 and 4 as an input to the decompression algorithm to produce decompressed information which may be without limitation a decompressed header. The other input is from the information to be decompressed which is illustrated without limitation in the example as headers to be decompressed.

Both the compression and decompression context informations are dynamic, that is, they may be updated by the compressor and decompressor respectively. The frequency of updates depends on the header compression mechanism. Events that may result in an update of the compression context information at the compressor include the compression of an incoming header, or the receipt of feedback from the decompressor. Events that may result in an update of the decompression context information at the decompressor include the decompression of an incoming header.
The Compressor can be in one of 3 states:
- FH (Full Header) state
- FO (First Order) state
- SO (Second Order) state

The compressor operates in the FH state in the initialization phase. In the FH state, the compressor sends a full RTP header. This state is normally just a transient state which only happens at the beginning of an RTP session or in the middle of a session due to very exceptional events, e.g., the compressor fails or loses memory.

The compressor operates in the FO state in the update phase. In the FO state, the transmitter sends a FO header, i.e. a packet whose header carries the fields that have changed compared to the reference header, appropriately encoded, along with the sequence number. The decompressor is expected to acknowledge as illustrated in Figs. 3 and 4 a certain number of FOs, where the number depends on the pattern. For example, if the pattern is linear with constant parameters, only one acknowledgment is needed to transition to the extrapolation phase.

The compressor operates in the SO state in the extrapolation phase. In this state, the transmitter sends a SO packet, i.e. a packet whose header is essentially just a sequence number. The decompressor may or may not acknowledge a correctly received SO packet.

A type of mathematical function, which may be used with the invention but to which the invention is not limited, used in VLE is described as follows. Such a function, denoted as f(k,v_ref)=(v_1, v_2,....,v_2^{k}), maps to an integer value v_ref called reference value and a number of bits k to a k-tuple of integers which all have different k LSBs.

Although any such function could be appropriate, one preferred embodiment uses only functions which return consecutive values v_1, v_2,....,v_2^{k}, i.e. v_i = v_1 + i-1. In other words, the function has an interval of length 2^{k} values. The interval can be written as ]v_ref-C(k, v_ref), v_ref-C(k, v_ref)+2^{k}] where C is an integer value which is function of k and v_ref. Here again, although any such interval could be of interest, one preferred embodiment uses C(k, v_ref)=0 and C(k,v_ref)=2^{k-1}. In other words, the embodiment uses the intervals ]v_ref-2^{k-1}, v_ref+2^{k-1}] and ]v_ref, v_ref+2^{k}].

A VLE embodiment based on the ]v_ref-2^{k-1}, v_ref+2^{k-1}] interval is described as follows. The system is composed of a compressor, a decompressor and a CD-channel as illustrated in Fig. 3 and 4, i.e. the link between the compressor and the decompressor. The channel may be error-prone. The only assumptions made with this embodiment, which are not limiting, are that compressed values are not reordered by the channel and the compressed values which are given as inputs to the decompressor are not corrupted (or in other words corrupted headers are treated as lost headers). The channel may be a simplex link, i.e. carries only compressed values from the decompressor or duplex, i.e. the channel carries also feedback from the decompressor to the compressor as illustrated in Figs. 3 and 4. In the preferred embodiment a duplex channel is used.

The first phase is the acquisition by the decompressor of an initial value. This may be performed by the compressor sending uncompressed values at the start of the communication or any other suitable means. The decompressor may use a feedback channel to acknowledge the received value as illustrated in Figs. 3 and 4. The initialization is completed without limitation when the compressor has received one feedback acknowledgment and VLE encoding can then be used for compression. In VLE, values are compressed as a variable number of bits k. The operation of the decompressor in the VLE mode is first discussed.

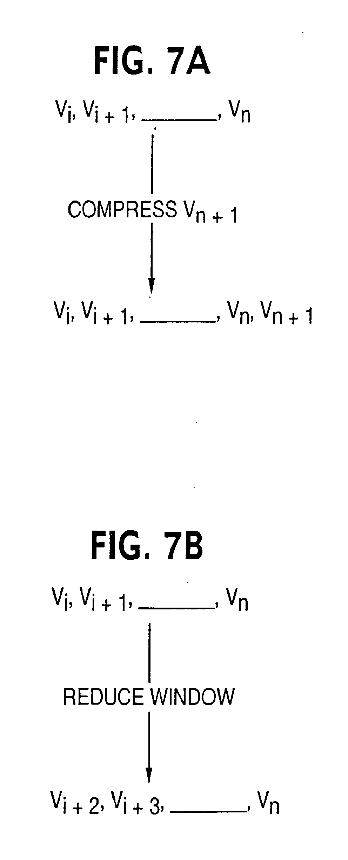

Figs. 7A and 7B illustrate a window update process. The window is comprised of previous values which are inputted to the compressor and may be compressed but are not required to be compressed. It is assumed that the window is vᵢ, vᵢ₊₁,____ ,vₙ at a contain point of time:
(1) When a new value Vₙ₊₁ is compressed, the window is enlarged in order to include this new value as illustrated in Fig. 7A.
(2) The window is then reduced, as illustrated in Fig. 7B, by removing older value(s) (in that example, vᵢ and Vᵢ₊₁) when the compressor knows that these values cannot be used by the decompressor anymore which, in this example, could be when the reception of an acknowledgment for the value vᵢ₊₂ occurs.

### Decompression:

The reference value is the last value decompressed by the decompressor. The compressor may be signalled of decompression by the reception of an acknowledgment as illustrated in Figs. 3 and 4 or on the assumption that an actual value has been received in view of the transmission of a series of values over sufficient time duration that at least one value is statistically likely to be received and decompressed without use of any feedback from the decompressor. The decompressor decompresses an incoming compressed value by providing the only value in the interval ]v_ ref-2^{k-1}, v_ref+2^{k-1}] whose k LSBs are a match of the k bits received. This search interval is a special instance of the functions introduced earlier. The decompressed value becomes the v_ref which will be in turn used to decompress the next incoming compressed value. In the preferred embodiment, the decompressor acknowledges at least some of the packets which have been decompressed such as illustrated in Figs. 3 and 4. The number of packets which have to be acknowledged is totally flexible and is chosen to meet the specifications of the desired application. The more acknowledgments which are transmitted from the decompressor to the compressor, the higher the compression efficiency on the forward link as will be shown hereafter.

### Compression:

Reference is now made to the compressor operations. The compressor maintains a sliding window of values it has compressed and transmitted to the decompressor which are illustrated in Figs. 7A and 7B. In the one embodiment, the window holds the latest value for which it has received an acknowledgment from the decompressor and all the following transmitted values in the order they were transmitted to the decompressor. The compressor also maintains the minimum and maximum values v_min and the v_max respectively of the sliding window.

When a new uncompressed value v reaches the compressor, the compressor sends k LSBs of v such that v be in the interval ]v_i-2^{k-1}, V_i+2^{k-1}] for every v_i of the sliding window. This can be conveniently expressed by r<2^{k}-1 where r = max(|v - v_max|, |v - v_min|). The compressor thus chooses k to be the smallest integer which is more than log₂(r)+1. When the compressor receives an acknowledgment, it removes from its window all the values which have been sent prior the acknowledged value as discussed above with reference to Fig. 7B.

The following discussion demonstrates why VLE always provides correct decompression and is a very flexible compression mechanism.

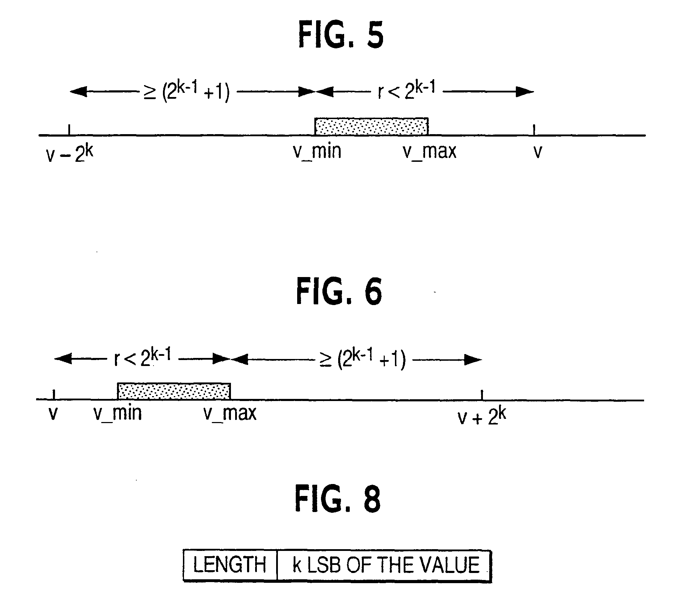

As long as the compressor and decompressor follow the above-described rules, correct decompression occurs whatever the losses are on the CD-channel between the compressor and decompressor as illustrated in Figs. 3 and 4. In effect, the reference value v_ref used by the decompressor necessarily belongs to the compressor window, as illustrated for example in Figs. 5 and 6 between points v_min and v_max, and therefore the encoded value is known to be in the interval ]v_ref-2^{k-1}, v_ref+2^{k-1}] which is the search interval used by the decompressor.

There is no error propagation with VLE. A compressed packet received by the decompressor can always be decompressed. Packet losses translate into a gradual increase in the compressed packet size.

The more frequent the acknowledgments, the less values in the window and therefore the less LSBs are likely to be sent. This holds especially in the case of header compression where the values to be compressed follow an increasing trend and where v-v_min increases for each new value v until an acknowledgment is received.

The length of the compressed value must be known to the decompressor. In some cases this length can be known without any additional signaling, for example through the framing information from lower layers of coding. If explicit signaling is needed the preferred embodiment defines a VLE format. The format may have two fields: the length field (i.e. k the number of LSB) and the compressed value field (i.e, k LSB of the original value v) as illustrated in Fig. 8.

In a preferred embodiment, the VLE length field, as illustrated in Fig. 8, is itself encoded using Huffman coding. Any other encoding methods (e.g. linear encoding) may be used. For different applications the likelihood of different lengths should be accessed and then a Huffman coding algorithm should be used to encode these data where desirable. The likelihood of encountering a given length on a communication link between the compressor and decompressor can be assessed knowing the link properties (loss and delay) and the decompressor acknowledgment period, as well as the patterns of the original values to be compressed.

To further reduce the length of the length field itself, the compressor may be constrained to choose the length of the field from a reduced set of values. For instance, assuming the uncompressed field is 32 bits and it is desired to encode with a maximum 2-bit length the following lengths which are in a decreasing order of likelihood 4 bits, 8 bits and 32 bits, appropriate code words could be the single bit 0 for 4 bits, the 2-bit value 1 0 for 8 bits and the 2-bit value 1 1 for 32 bits.

Using appropriate coding minimizes the average size of the compressed values.

Furthermore, the length information may not require dedicated bits if the length can be derived from other packet fields. For example, in a typical header compression application a packet type field is transmitted in the compressed header. This packet type field can be used to imply a default length which is rarely exceeded. In the case, where the default length is exceeded, a separate packet type is used. Since this happens only rarely the overhead is overall decreased.

If there is no feedback channel, other (out-of-band) information or additional assumptions are required to move the compressor window forward and keep the k from increasing forever. One way is to assume that at most L consecutive compressed values can be lost along the channel from the compressor to the decompressor. In other words, the compressor knows for sure that at least one out of (L + 1) consecutive compressed values arrives at the decompressor. Therefore, the compressor only needs to store in the window the last (L + 1) values that have been sent to the decompressor. Therefore, the range (v_max - v_min), and thus the value of k, depends only on the last (L + 1) values sent.

VLE can be applied to RTP header compression. Conversely to RFC 2508, there is no need to use a compressor- decompressor sequence number. Instead, the RTP sequence number is encoded using VLE. The decompressor acknowledges packets such as illustrated in Figs. 3 and 4 as described in the VLE application by sending to the compressor the RTP SN it has received.

As discussed below regarding optimal acknowledgments, the decompressor does not have to return the uncompressed RTP SN value.

The following example illustrates the working of the present invention for RTP SN compression as set forth in RFC 2508. A series of incoming packets are provided to the compressor whose SN (sequence number) are: 32, 33, 35, 36, 39, 40, 38, 41. Assuming that the decompressor has acknowledged the packet whose sequence number is 35, the compressor keeps a window of sequence numbers as discussed above transmitted since the last acknowledged packet. When the acknowledgment is received, the compressor window is thus: 35, 36, 39, 40, 38, 41. Now it is assumed that a new SN value is coming to the compressor having a SN value of 43. The compressor looks for its window maximum and finds 41. The compressor looks for is window minimum and finds 35. The compressor computes the distance r of the incoming value to its upper (43-41 = 2) and lower (43-35 = 8) bounds. The maximum distance is 8. The compressor has to transmit a number of bits k such that the integer is more than log₂^{r}+1 with 2^{k} being greater than 17 in this example. This number is k=5. Since 43 is written in binary format as 101011, the compressor sends the 5 LSB, i.e. 01011. The decompressor reference value is the last value decompressed by the decompressor and it is for sure one of the values in the compressor window. The decompressor decompresses the incoming value (01011) by returning the value whose 5 LSBs are 01011 and which is the closest to the reference value. Whatever the reference value, this value will always be 43. For example, if it is assumed that the last value received by the decompressor is 40 when it receives the compressed value (i.e. 38 and 41 were lost on the link between the compressor and the decompressor), the search interval used by the decompressor is [25, 56] or in binary format [011001, 111000]. The only value in the interval whose last LSBs are 01011 is 101011, i.e. 43.

Another way for the decompressor to pick the value of k is to choose the closest value to 40 whose LSBs are 01011. The number 40 is 101000 in binary format. The closest value to 101000 whose last LSBs are 01011 is 01011, i.e. 43. This illustrates that whatever the losses on the compressor-decompressor link, the VLE allows determination of the minimum or reduced number of LSB bits to be sent which will provide correct decompression.

Figs. 5 and 6 illustrate the picking of k such that the current value to be VLE encoded is among the values having the same LSB and is closest to either a maximum or a minimum in the window. Fig. 5 illustrates the case where v is greater than v_max and Fig. 6 illustrates the case where V is less than v_min.

In the packets where the RTP time stamp or the IP-ID field is sent, these fields are encoded using the same window of transmitted packets as used for SN encoding. Therefore, the decompressor does not send back these fields on the reverse/feedback channel in order to acknowledge them. The window can also be seen as a window of vectors (SN, TS, IP-ID). A given vector can be acknowledged by returning only the SN field.

One embodiment performs header compression based on an acknowledgment framework to transmit SN, TS and IP-ID when these fields have to be transmitted. Other encodings can be used for TS and IP-ID. This header compression scheme is summarized below.

### Transition to FO and SO States Using Acknowledgments

When a new session starts, the compressor operates in FH state until receiving an acknowledgment (ACK) from the decompressor, indicating that at least one FH packet has been received. It is the responsibility of the decompressor to acknowledge an FH packet as soon as it receives it, so that the compressor can transit from FH state to FO state. Acknowledgments may contain either the compressed current value which is decompressed by the decompressor or the uncompressed current value. Either quantity permits the compressor to update the state of compression and initiate discarding of the old values.

In the FO state, the compressor transmits FO packets and the decompressor is supposed to acknowledge received FO packets (not necessarily every FO packet). If the compressor determines (based on the ACKs) that the decompressor has established an FOD, and that FOD is same as the FOD between the current header being transmitted and the last transmitted header, the compressor then advances to SO state and starts sending SO packets.

Due to the reasons discussed above, the compressor may have to fallback from SO state to FO state. However, the compressor never transits back to FH state unless some exceptional events happen, such as decompressor loses its contexts because of system crash. Whenever the compressor is in FO state, it tries to advance to SO state as described above.

Suitable packet types are disclosed in Application Serial No. 09/536,639, filed on March 28,2000, entitled "Method and System for Transmitting and Receiving Packets".

Two variations of VLE, referred to Fixed Length Encoding (FLE) and One Sided Variable Length Encoding (OVLE) are described below.

### Fixed Length Encoding (FLE)

Fixed length encoding may be used, if it is known for sure that, the range r = (v_max - v_min) never exceeds an upper-bound. Every value is encoded with the same number of bits which is the smallest number of bits needed to cover this range. The length does not need to be transmitted in that case since it is assumed to be a known constant.

### One Sided Variable Length Encoding (OVLE)

The previously described VLE is based on a function which maps to a reference value v_ref and a number of bits k which returns the search interval ]v_ref-2^{k-1}, v_ref+2^{k-1}]. This is very general and flexible, as it can accommodate arbitrary changes (positive, negative) from one value to the next. However, this interval is not the most efficient when used for a field which is monotonic. In effect, the decompressor picks up a decompressed value only in the subset ]v_ref, v_ref+2^{k-1}].

In the case of RTP header compression, the fields usually arrive to the compressor in increasing order. However, there are exceptions because of possible misordering upstream from the compressor or in the case of the timestamp, an encoder might not deliver the coded frames in the order they were sampled. In order to improve efficiency, it may be worth using a function which would return a search interval which is not centered on v_ref, for instance the interval ]v_ref-2^{k-2}, v_ref+3*2^{k-2}].

When VLE is used as part of an adaptive header compression application, it is possible to use the interval ]v_ref, v_ref+2^{k}] which is the most efficient for a given k. This is referred to as one sided variable length encoding (OVLE). VLE is used for FO packets and OVLE for SO packets as long as the compressor incoming values are increasing. In the case that a misordering of packets occurs before the compressor, the compressor always compresses the packet as an FO packet. Alternatively, the compressor could reorder and/or drop packets in order to stay in the SO state even if misordering occurs.

### An Optimal Acknowledgment Algorithm for the Variable Length Encoding (VLE) and One-sided VLE (OVLE) of Compressed Data

To improve the overall compression efficiency, it is desirable to keep the size of the acknowledgment sent by the decompressor to the compressor to a minimum. In the algorithm discussed herein, the decompressor only needs to send in an acknowledgment the same number of bits (or at most 2 more bits, as described later) as it has received in the compressed message.

As described in VLE and OVLE, the compressor maintains a sliding window of values VSW and stores each of the original uncompressed values in VSW after transmission to the decompressor.
VSW: v₁, v₂, v_{3,}... v₄....vₙ Note: v₁, is the oldest value, and vₙ the youngest)

### Case 1: Single Encoding Method

It is assumed that only one encoding method is used (either VLE or OVLE) and both the compressor and the decompressor know which one is being used. When the decompressor successfully receives a compressed value and decides to acknowledge it, it simply copies the received compressed value into the acknowledgment and transmits it back to the compressor.

When the compressor receives an acknowledgment message, it processes the acknowledgment in the following three steps:
1) Uses V₁ (the oldest value) in VSW as the reference value and decompresses the compressed value in the acknowledgment following the same rules as the decompressor. The decompressed value is identified as v_acked.
2) Searches the VSW from head (oldest) to tail (youngest), for the first (oldest) occurrence of v_acked.
3) Deletes all the values preceding (older than) v_acked.

It can be shown that the above algorithm works by observing the following property of the VSW:
• If vᵢ in HSW was sent by the compressor using k bits, it can be correctly decompressed using the same k bits and using any Vᵢ(j≤i) as the reference value.

Specifically, v₁ can be used as the reference value to decompress any value in the VSW. Combined with the fact that an acknowledgment always acknowledges one of the values in the VSW, it is concluded that v_acked derived in step 1) is indeed the correct original value that triggered the acknowledgment message.

### Case 2: Multiple Encoding Methods

In this case, the decompressor dynamically switches encoding methods between VLE and OVLE. It is only needed to change the aforementioned algorithm slightly to handle this case. Basically, in each acknowledgment message, the decompressor must add a flag to indicate which encoding method was used to compress the received value. Therefore, when the compressor receives an acknowledgment message, it can choose the correct decompression method based on the encoding flag in the acknowledgment. As long as the property of the VSW holds, the modified algorithm is correct, based on the same reasoning as in the previous section.

Also when VLE and/or OVLE are applied to header compression, the encoding flag need not be carried explicitly in the compressed headers sent from the compressor to the decompressor, since decompressor can derive that information implicitly based on header type and other configuration information. However, on the reverse direction, the flag has to be carried explicitly in the acknowledgment message. In the worst case, 2 bits are needed to differentiate three possibilities: VLE, plus-sided OVLE, minus-side OVLE. The encoding flag could be reduced to one bit if the side information of OVLE is predefined.

### Duplicated values in VSW

There is one special case that has not been discussed above. It is possible that the same (original uncompressed) value may occur more than once in the compressor sliding window. This needs to be considered for the following two reasons: 1) in theory, the algorithm should be generic and work for any sequence of values; 2) in practice, RTP Timestamps for some video codes do have this behavior.

The problem is that, although the calculated value v_acked is still correct, the compressor cannot determine which occurrence (if it found multiple occurrences) of the v_acked in VSW actually triggered the ACK.

However, it should be noted that the algorithm works, since the compressor always chooses the first (oldest) occurrence of v_acked in VSW. If it is not the correct instance that triggered the acknowledgment, the only side effect is that less values were deleted from the VSW than should have been. As a result, the new values arriving thereafter may be encoded using more bits than necessary.

If a duplication of values seldom occurs, no modification to the aforementioned algorithm is necessary, since the compressor is brought out of its less-than-optimal state as soon as another (unambiguous) acknowledgment arrives which acknowledges a value that occurs only once in the VSW.

If duplicated values are expected to happen frequently, extra information may be added to remove the ambiguity of an acknowledgment. One example is to assign a generation number (GN) to each compressed value and require the decompressor to put the GN in the acknowledgment.

While the invention has been described with reference to its preferred embodiments, it should be understood that numerous modifications may be made thereto without departing from the scope of the appended claims.

## Claims

1. A method of decompressing a compressed value received from a compressor, the method comprising:
acquiring a reference value;
receiving a value which is compressed into a minimum, or reduced, number of k least significant bits from the compressor;
matching the k least significant bits with values within a search interval determined by the reference value; and
determining the matched value as the decompressed value.

2. A method according to claim 1, wherein the search interval is proximate to the reference value.

3. A method according to claim 1 or 2 wherein said decompressed value is determined to be the matched value closest to said reference value.

4. A method according to claim 1, 2 or 3, wherein the search interval is between 2^{k-1} above and below the reference value.

5. A method according to any one of claims 1, 2 or 3, wherein the search interval is unequally centred around the reference value.

6. A method according to any one of claims 1 to 5 wherein the matched decompressed value becomes the reference value

7. A method according to any preceding claim, comprising sending an acknowledgement from the decompressor to the compressor when said decompressed value is determined.

8. A method according to claim 7, wherein the decompressed value which is acknowledged is a full RTP header.

9. A method according to either one of claims 7 or 8, wherein the acknowledgement has k bits.

10. A method according to any one of claims 7, 8 or 9, wherein the acknowledgement comprises a copy of the compressed value received from the compressor.

11. A method according to any one of claims 7 to 10, wherein the acknowledgement is encoded in the decompressor prior to transmission to the compressor.

12. A method according to claim 11, wherein the decompressor includes a flag in the acknowledgement indicating the type of encoding used to compress the acknowledgement.

13. A method according to claim 12, wherein the flag comprises 2 bits.

14. A method according to any one of claims 7 to 13, wherein the acknowledgement includes a generation number.

15. A method according to any preceding claim, comprising transmitting the value of k between the compressor and decompressor, wherein the value of k is encoded using Huffman coding prior to transmission.

16. A method according to any preceding claim, wherein the value of k is dependent upon the maximum number of consecutive compressed values lost between the compressor and decompressor.

17. A decompressor for decompressing a compressed value received from a compressor, the decompressor comprising:
means for acquiring a reference value;
means for receiving a value which is compressed into a minimum, or reduced, number of k least significant bits from the compressor;
matching means for matching the k least significant bits with values within a search interval determined by the reference value; and
determining means for determining the matched value as the decompressed value.

18. A decompressor according to claim 17, wherein the matching means is operable such that the search interval is proximate to the reference value.

19. A decompressor according to either claim 17 or 18 wherein said determining means is operable such that the decompressed value is determined to be the matched value closest to said reference value.

20. A decompressor according to claim 17, 18 or 19, wherein the matching means is operable such that the search interval is between 2^{k-1} above and below the reference value.

21. A decompressor according to any one of claims 17, 18 or 19, wherein matching means is operable such that the search interval is unequally centred around the reference value.

22. A decompressor according to any one of claims 17, 18 or 19, wherein the matched means is operable such that the matched decompressed value becomes the reference value.

23. A decompressor according to any one of claims 17 to 22, comprising sending means operable to send an acknowledgement from the decompressor to the compressor when said decompressed value is determined.

24. A decompressor according to claim 23, wherein the decompressed value which is acknowledged is a full RTP header.

25. A decompressor according to either one of claims 23 or 24, wherein the sending means is operable such that the sent acknowledgement has k bits.

26. A decompressor according to any one of claims 23, 24 or 25, comprising means to copy the compressed value received from the compressor and wherein the sending means is operable such that the sent acknowledgement comprises a copy of the compressed value.

27. A decompressor according to any one of claims 23 to 26, wherein the sending means is operable such that the acknowledgement is encoded in the decompressor prior to transmission to the compressor.

28. A decompressor according to claim 27, wherein the sending means is operable to include a flag in the acknowledgement indicating the type of encoding used to compress the acknowledgement.

29. A decompressor according to claim 28, wherein the flag comprises 2 bits.

30. A decompressor according to any one of claims 23 to 29, wherein the sending means is operable such that the acknowledgement includes a generation number.

31. A decompressor according to any of claims 17 to 30, wherein the sending means is operable such that the value of k is encoded using Huffman coding prior to transmission.

32. A decompressor according to any of claims 17 to 31, operable such that the value of k is dependent upon the maximum number of consecutive compressed values lost between the compressor and decompressor.

33. A computer program comprising machine readable instructions which when executed by computer apparatus control it to perform the method of any of claims 1 to 16.

## Patentansprüche

1. Dekompressionsverfahren für einen komprimierten von einer Kompressionseinrichtung empfangenen Wert, wobei das Verfahren aufweist:
Erhalten eines Referenzwerts;
Empfangen eines Werts, der auf eine Minimalanzahl k niedrigstwertigster Bits von der Kompressionseinrichtung komprimiert oder gekürzt ist;
Anpassen der k niedrigstwertigsten Bits an Werte innerhalb eines durch den Referenzwert bestimmten Suchintervalls; und
Bestimmen des Abgleichwerts als den dekomprimierten Wert.

2. Verfahren gemäß Anspruch 1, wobei das Suchintervall dem Referenzwert benachbart ist.

3. Verfahren gemäß Anspruch 1 oder 2, wobei der dekomprimierte Wert bestimmt wird, dass der angepasste Wert der dem Referenzwert Nächste ist.

4. Verfahren gemäß Anspruch 1, 2 oder 3, wobei das Suchintervall zwischen 2^{k-1} über und unter dem Referenzwert ist.

5. Verfahren gemäß einem der Ansprüche 1, 2 oder 3, wobei das Suchintervall ungleichmäßig um den Referenzwert herum liegt.

6. Verfahren gemäß einem der Ansprüche 1 bis 5, wobei der angepasste dekomprimierte Wert der Referenzwert wird.

7. Verfahren gemäß einem der vorhergehenden Ansprüche, mit Senden einer Bestätigung von der Dekompressionseinrichtung an die Kompressionseinrichtung, sobald der dekomprimierte Wert bestimmt ist.

8. Verfahren gemäß Anspruch 7, wobei der dekomprimierte Wert, der bestätigt wird, ein vollständiger RTP-Header ist.

9. Verfahren gemäß Anspruch 7 oder 8, wobei die Bestätigung k Bits besitzt.

10. Verfahren gemäß einem der Ansprüche 7, 8 oder 9, wobei die Bestätigung eine Kopie des komprimierten von der Kompressionseinrichtung empfangenen Werts aufweist.

11. Verfahren gemäß einem der Ansprüche 7 bis 10, wobei die Bestätigung in der Dekompressionseinrichtung vor der Übertragung an die Kompressionseinrichtung kodiert wird.

12. Verfahren gemäß Anspruch 11, wobei die Dekompressionseinrichtung ein Flag in die Bestätigung einfügt, das den Typ der zum Komprimieren der Bestätigung verwendeten Kodierung anzeigt.

13. Verfahren gemäß Anspruch 12, wobei das Flag 2 Bits aufweist.

14. Verfahren gemäß einem der Ansprüche 7 bis 13, wobei die Bestätigung eine Generationsnummer enthält.

15. Verfahren gemäß einem der vorhergehenden Ansprüche, mit Übertragen des Wertes von k zwischen der Kompressionseinrichtung und der Dekompressionseinrichtung, wobei der Wert von k unter Verwendung einer Huffman-Kodierung vor der Übertragung kodiert wird.

16. Verfahren gemäß einem der vorhergehenden Ansprüche, wobei der Wert von k von der Maximalanzahl aufeinander folgender komprimierter zwischen der Kompressions- und Dekompressionseinrichtung verlorener Werte abhängig ist.

17. Dekompressionseinrichtung zum Dekomprimieren eines komprimierten von einer Kompressionseinrichtung empfangenen Werts, wobei die Dekompressionseinrichtung aufweist:
Mittel zum Erhalten eines Referenzwerts;
Mittel zum Empfangen eines Werts, der auf eine Minimalanzahl von k niedrigstwertigster Bits von der Kompressionseinrichtung komprimiert oder gekürzt ist;
Anpassungsmittel zum Anpassen der k niedrigstwertigsten Bits mit Werten innerhalb eines Suchintervalls, das durch den Referenzwert bestimmt ist; und
Bestimmungsmittel zum Bestimmen des angepassten Werts als den dekomprimierten Wert.

18. Dekompressionseinrichtung gemäß Anspruch 17, wobei die Anpassungsmittel derart betreibbar sind, dass das Suchintervall dem Referenzwert benachbart ist.

19. Dekompressionseinrichtung gemäß Anspruch 17 oder 18, wobei die Bestimmungsmittel derart betreibbar sind, dass der dekomprimierte Wert bestimmt wird, dass er der angepasste Wert am Nächsten zum Referenzwert ist.

20. Dekompressionseinrichtung gemäß Anspruch 17, 18 oder 19, wobei die Anpassungsmittel derart betreibbar sind, dass das Suchintervall zwischen über 2^{k-1} und unter dem Referenzwert ist.

21. Dekompressionseinrichtung gemäß einem der Ansprüche 17, 18 oder 19, wobei die Anpassungsmittel derart betreibbar sind, dass das Suchintervall ungleich um den Referenzwert herum liegt.

22. Dekompressionseinrichtung gemäß einem der Ansprüche 17, 18 oder 19, wobei die Anpassungsmittel derart betreibbar sind, dass der angepasste dekomprimierte Wert der Referenzwert wird.

23. Dekompressionseinrichtung gemäß einem der Ansprüche 17 bis 22, aufweisend Sendemittel, die betreibbar sind, eine Bestätigung von der Dekompressionseinrichtung an die Kompressionseinrichtung zu senden, sobald der dekomprimierte Wert bestimmt ist.

24. Dekompressionseinrichtung gemäß Anspruch 23, wobei der dekomprimierte Wert, der bestätigt wird, ein vollständiger RTP-Header ist.

25. Dekompressionseinrichtung gemäß Anspruch 23 oder 24, wobei die Sendemittel derart betreibbar sind, dass die gesendete Bestätigung k Bits hat.

26. Dekompressionseinrichtung gemäß einem der Ansprüche 23, 24 oder 25, mit Mitteln zum Kopieren des komprimierten Werts, der von der Kompressionseinrichtung empfangen wurde, und wobei die Sendemittel derart betreibbar sind, dass die gesendete Bestätigung eine Kopie des komprimierten Werts aufweist.

27. Dekompressionseinrichtung gemäß einem der Ansprüche 23 bis 26, wobei die Sendemittel derart betreibbar sind, dass die Bestätigung in der Dekompressionseinrichtung vor Übertragen an die Kompressionseinrichtung kodiert wird.

28. Dekompressionseinrichtung gemäß Anspruch 27, wobei die Sendemittel betreibbar sind, ein Flag in die Bestätigung einzufügen, das den Typ der zum Komprimieren der Bestätigung verwendeten Kodierung anzeigt.

29. Dekompressionseinrichtung gemäß Anspruch 28, wobei das Flag 2 Bits aufweist.

30. Dekompressionseinrichtung gemäß einem der Ansprüche 23 bis 29, wobei die Sendemittel derart betreibbar sind, dass die Bestätigung eine Generationsnummer enthält.

31. Dekompressionseinrichtung gemäß einem der Ansprüche 17 bis 30, wobei die Sendemittel derart betreibbar sind, dass der Wert von k unter Verwendung einer Huffman-Kodierung vor dem Übertragen kodiert wird.

32. Dekompressionseinrichtung gemäß einem der Ansprüche 17 bis 31, derart betreibbar, dass der Wert von k von der Maximalanzahl aufeinander folgender komprimierter zwischen der Kompressionseinrichtung und der Dekompressionseinrichtung verlorener Werte abhängig ist.

33. Computerprogramm mit maschinenlesbaren Befehlen, die sobald sie durch eine Computereinrichtung ausgeführt werden, diese steuern, das Verfahren gemäß einem der Ansprüche 1 bis 16 durchzuführen.

## Revendications

1. Procédé de décompression d'une valeur compressée reçue d'un compresseur, le procédé comprenant :
l'acquisition d'une valeur de référence ;
la réception d'une valeur qui est compressée en un nombre minimum, ou réduit, de k bits de poids faible en provenance du compresseur;
la mise en concordance des k bits de poids faible avec des valeurs situées dans un intervalle de recherche déterminé par la valeur de référence ; et
la détermination de la valeur concordante comme étant la valeur décompressée.

2. Procédé selon la revendication 1, dans lequel l'intervalle de recherche est proche de la valeur de référence.

3. Procédé selon la revendication 1 ou 2, dans lequel ladite valeur décompressée est déterminée comme étant la valeur concordante la plus proche de ladite valeur de référence.

4. Procédé selon la revendication 1, 2 ou 3, dans lequel l'intervalle de recherche est entre 2^{k-1} au-dessus et en dessous de la valeur de référence.

5. Procédé selon l'une quelconque des revendications 1, 2 ou 3, dans lequel l'intervalle de recherche est centré inégalement autour de la valeur de référence.

6. Procédé selon l'une quelconque des revendications 1 à 5, dans lequel la valeur décompressée concordante devient la valeur de référence.

7. Procédé selon l'une quelconque des revendications précédentes, comprenant l'envoi d'un acquittement du décompresseur au compresseur lorsque ladite valeur décompressée est déterminée.

8. Procédé selon la revendication 7, dans lequel la valeur décompressée qui est acquittée est un en-tête RTP complet.

9. Procédé selon l'une quelconque des revendications 7 ou 8, dans lequel l'acquittement comporte k bits.

10. Procédé selon l'une quelconque des revendications 7, 8 ou 9, dans lequel l'acquittement comprend une copie de la valeur compressée reçue du compresseur.

11. Procédé selon l'une quelconque des revendications 7 à 10, dans lequel l'acquittement est codé dans le décompresseur avant sa transmission au compresseur.

12. Procédé selon la revendication 11, dans lequel le décompresseur comprend un indicateur situé dans l'acquittement et indiquant le type de codage utilisé pour compresser l'acquittement.

13. Procédé selon la revendication 12, dans lequel l'indicateur comporte 2 bits.

14. Procédé selon l'une quelconque des revendications 7 à 13, dans lequel l'acquittement comprend un numéro de génération.

15. Procédé selon l'une quelconque des revendications précédentes, comprenant la transmission de la valeur de k entre le compresseur et le décompresseur, dans laquelle la valeur de k est codée par codage de Huffman avant sa transmission.

16. Procédé selon l'une quelconque des revendications précédentes, dans lequel la valeur de k est fonction du nombre maximum de valeurs compressées consécutives perdues entre le compresseur et le décompresseur.

17. Décompresseur pour décompresser une valeur compressée reçue d'un compresseur, le décompresseur comprenant :
des moyens d'acquisition d'une valeur de référence ;
des moyens de réception d'une valeur qui est compressée en un nombre minimum, ou réduit, de k bits de poids faible en provenance du compresseur ;
des moyens de mise en concordance pour mettre en concordance les k bits de poids faible avec des valeurs situées dans un intervalle de recherche déterminé par la valeur de référence ; et
des moyens de détermination pour déterminer la valeur concordante comme étant la valeur décompressée.

18. Décompresseur selon la revendication 17, dans lequel les moyens de mise en concordance fonctionnent de telle sorte que l'intervalle de recherche est proche de la valeur de référence.

19. Décompresseur selon la revendication 17 ou 18, dans lequel lesdits moyens de détermination fonctionnent de telle sorte que la valeur décompressée est déterminée comme étant la valeur concordante la plus proche de ladite valeur de référence.

20. Décompresseur selon la revendication 17, 18 ou 19, dans lequel les moyens de mise en concordance fonctionnent de telle sorte que l'intervalle de recherche est entre 2^{k-1} au-dessus et en dessous de la valeur de référence.

21. Décompresseur selon la revendication 17, 18 ou 19, dans lequel les moyens de mise en concordance fonctionnent de telle sorte que l'intervalle de recherche est centré inégalement autour de la valeur de référence.

22. Décompresseur selon l'une quelconque des revendications 17, 18 ou 19, dans lequel les moyens de mise en concordance fonctionnent de telle sorte que la valeur décompressée concordante devient la valeur de référence.

23. Décompresseur selon l'une quelconque des revendications 17 à 22, comprenant des moyens d'envoi qui fonctionnent de manière à envoyer un acquittement du décompresseur au compresseur lorsque ladite valeur décompressée est déterminée.

24. Décompresseur selon la revendication 23, dans lequel la valeur décompressée qui est acquittée est un en-tête RTP complet.

25. Décompresseur selon l'une quelconque des revendications 23 ou 24, dans lequel les moyens d'envoi fonctionnent de telle sorte que l'acquittement envoyé comporte k bits.

26. Décompresseur selon l'une quelconque des revendications 23, 24 ou 25, comprenant des moyens pour copier la valeur compressée reçue du compresseur et dans lequel les moyens d'envoi fonctionnent de telle sorte que l'acquittement envoyé comprend une copie de la valeur compressée.

27. Décompresseur selon l'une quelconque des revendications 23 à 26, dans lequel les moyens d'envoi fonctionnent de telle sorte que l'acquittement est codé dans le décompresseur avant sa transmission au compresseur.

28. Décompresseur selon la revendication 27, dans lequel les moyens d'envoi fonctionnent de manière à inclure un indicateur situé dans l'acquittement et indiquant le type de codage utilisé pour compresser l'acquittement.

29. Décompresseur selon la revendication 28, dans lequel l'indicateur comporte 2 bits.

30. Décompresseur selon l'une quelconque des revendications 23 à 29, dans lequel les moyens d'envoi fonctionnent de telle sorte que l'acquittement comprend un numéro de génération.

31. Décompresseur selon l'une quelconque des revendications 17 à 30, dans lequel les moyens d'envoi fonctionnent de telle sorte que la valeur de k est codée par codage de Huffman avant sa transmission.

32. Décompresseur selon l'une quelconque des revendications 17 à 31, fonctionnant de telle sorte que la valeur de k est fonction du nombre maximum de valeurs compressées consécutives perdues entre le compresseur et le décompresseur.

33. Programme informatique comprenant des instructions lisibles par une machine lesquelles, lorsqu'elles sont exécutées par un ordinateur, commandent celui-ci pour l'exécution du procédé selon l'une quelconque des revendications 1 à 16.
